# EUROPEAN PATENT APPLICATION

(11) **EP 4 391 208 A1**
(43) Date of publication of application: **26.06.2024**
(21) Application number: 23215389.0
(22) Date of filing: 08.12.2023
(51) Int. Cl.: H01M 50/569, H01M 50/298, H01M 50/242, H01M 50/287, H01M 10/48, H01M 50/209, H01M 50/211, H01M 50/249, H01M 50/264, H01M 10/42

(54) **UNIFIED BATTERY CELL SENSOR INTEGRATED BATTERY MODULE**

(30) Priority: 23.12.2022 KR 20220183324
(71) Applicant: H GREEN POWER Inc., Chungju-si 27465 (KR)
(72) Inventor: KIM, Jung-Hwan, 27465 Chungju-si (KR); KANG, Sung-Joo, 27465 Chungju-si (KR); PARK, Sung-Hwan, 27465 Chungju-si (KR); KIM, Gil-Seob, 27465 Chungju-si (KR); SONG, Pu-Rue-Reom, 27465 Chungju-si (KR)
(74) Representative: Cabinet Laurent & Charras

(57) **Abstract**

The present invention relates to a unified battery cell sensor integrated battery module, and more particularly, to a unified battery cell sensor integrated battery module that is simple in structure, excellent in assemblability, and capable of immediately and accurately detect abnormalities in the battery cells. The unified battery cell sensor integrated battery module includes an end plate part 200 positioned on the left and right sides of the battery module and a unified sensor part 400 formed integrally on the end plate part 200 and configured to sense at least one of voltage or temperature of a battery cell 300, which is simple in structure, excellent in assemblability, and capable of immediately and accurately detect abnormalities in the battery cells.

## Description

### BACKGROUND OF THE INVENTION

### Field of the Invention

The present invention relates to a unified battery cell sensor integrated battery module, and more particularly, to a unified battery cell sensor integrated battery module that is simple in structure, excellent in assemblability, and capable of immediately and accurately detect abnormalities in the battery cells.

### Description of the Related Art

Recently, the increasing focus on environmental issues and energy challenges has led to the rapid proliferation of electric vehicles.

As a crucial component of electric vehicles, the battery cell must ensure safety in addition to enhancing performance.

In other words, there is a significant need for real-time confirmation of any abnormalities in electric vehicle battery cells compared to other components.

This is particularly crucial as extinguishing a fire in the battery cell of electric vehicles is highly challenging once it occurs.

Therefore, technologies are being attempted to immediately confirm abnormalities in the battery, such as early signs of thermal runaway in the cell, namely swelling, through abnormal state monitoring of the battery cells.

Accordingly, in the past, various sensors were placed inside and outside the cell or module to detect abnormalities such as battery cell swelling.

Traditionally, a separate structure had to be installed to sense the voltage and temperature of the battery module for voltage monitoring.

In other words, separate structures such as a flexible printed circuit board (FPCB), sensing wires, and an upper cover for fixation were utilized to connect the front and rear of the battery module.

However, with this traditional technology, there were problems of reduced assemblability and difficulty in process automation due to tolerances and clearances among assembly components.

Furthermore, using such conventional technologies still posed limitations in accurately and reliably confirming battery abnormalities.

### Documents of Related Art

(Patent Document 1) KR 2022-0065159 A

### SUMMARY OF THE INVENTION

The present invention has been conceived the above problems and it is an object of the present invention to provide a unified battery cell sensor integrated battery module that is simple in structure, excellent in assemblability, and capable of immediately and accurately detect abnormalities in the battery cells.

A unified battery cell sensor integrated battery module includes an end plate part 200 positioned on the left and right sides of the battery module, and a unified sensor part 400 formed integrally on the end plate part 200 and configured to sense at least one of voltage or temperature of a battery cell 300.

In addition, the unified sensor part 400 includes a wire part 402 including a first voltage sensing part 403 and a second voltage sensing part 404 configured each to measure voltage at the front and rear ends of the battery module, a temperature sensing part 401 formed integrally on the wire part 402 and configured to contact the battery cell 300 and sense the temperature of the battery cell 300.

In addition, the end plate part 200 includes an outer plate part 210 and an inner plate part 220 coupled with the outer plate part 210 on one side thereof and facing the battery cell 300 on the other side, wherein the temperature sensing part 401 is positioned between the inner plate part 220 and the battery cell 300.

In addition, the temperature sensing part 401 includes a temperature sensor configured to sensing the temperature of the battery cell 300, and the inner plate part 220 includes a compartment 225 facing the outer plate part 210 at a position corresponding to the temperature sensor to accommodate the temperature sensor in response to swelling of the battery cell 300.

In addition, the temperature sensor includes a first temperature sensor 411 and a second temperature sensor 412 positioned at a predetermined distance from each other vertically.

In addition, the first temperature sensor 411 is positioned on the upper side of the temperature sensing part 410 to sense the temperature at the top of the battery cell 300, and the second temperature sensor 412 is positioned on the lower side of the temperature sensing part 401 to sense the temperature at the bottom of the battery cell 300.

In addition, the temperature sensing part 401 includes a pad part 413 around each of the first temperature sensor 411 and the second temperature sensor 412, and the inner plate part 220 includes a first recessed portion 221 and a second recessed portion 222 formed deeper than the first recessed portion 221 facing the outer plate 210, the pad part 413 being situated in the first recessed portion 221.

In addition, the first temperature sensor 411 is mounted at the center of the pad part 413.

In addition, the outer plate part 210 includes a second round portion 212 formed in a convex shape away from the inner plate 220 at a position facing each of the first temperature sensor 411 and the second temperature sensor 412.

In addition, the temperature sensing part 401 includes an adhesive portion 414 to be fixed to the inner plate part 220.

In addition, the adhesive portion 414 is positioned between the first temperature sensor 411 and the second temperature sensor 412.

In addition, the end plate part 200 includes an air gap part 201 configured to dissipate heat generated during welding.

In addition, the end plate part 200 includes a first guide part 202 and a second guide part 203 protruded upward at the top thereof to guide the wiring work of the wire part 402.

In addition, the first guide part 202 and the second guide part 203 are formed in a zigzag pattern at the top of the inner plate part 220.

A unified battery cell sensor integrated battery module includes an end plate part 200 contacting a battery cell 300, and a unified sensor part 400 provided integrally on the end plate part 200 and configured to sense at least one of voltage or temperature of a battery cell 300, wherein the unified sensor part 400 includes a wire part 402 including a first voltage sensing part 403 and a second voltage sensing part 404 configured each to measure voltage at the front and rear ends of the battery module, and a temperature sensing part 401 formed integrally on the wire part 402 and configured to contact the battery cell 300 and sense the temperature of the battery cell 300, the temperature sensing part 401 including a first temperature sensor 411 and a second temperature sensor 412 to measure temperature at the top and bottom of the battery module.

### BRIEF DESCRIPTION OF THE DRAWINGS

FIG. 1 is a perspective view illustrating a battery module 100 according to a preferred embodiment of the present invention;
FIG. 2 is an exploded perspective view illustrating an end plate part 200 according to a preferred embodiment of the present invention;
FIG. 3 is a perspective view illustrating an end plate 200 according to a preferred embodiment of the present invention; and
FIG. 4 is a cross-sectional view illustrating an end plate part 200 according to a preferred embodiment of the present invention.

### DETAILED DESCRIPTION OF THE INVENTION

The present invention can be implemented in diverse embodiments with various modifications, as specifically illustrated in the drawings and comprehensively described in the specification. However, this is not intended to limit the present invention to specific embodiments, and it should be understood that all modifications, equivalents, and substitutions fall within the scope and spirit of the present invention.

When providing descriptions with reference to the attached drawings, similar reference symbols are used for similar components.

The terms such as 'first' and 'second' can be used to describe various components, the components should not be limited by these terms. The terms are used only for distinguishing one component from another component.

For example, a first component may be referred to as a second component and, similarly, the second element may be referred to as the first component, without departing from the scope of the present invention. The term "and/or" includes a combination of a plurality of related items enumerated or any of a plurality of related items enumerated.

Unless otherwise defined herein, all terms including technical or scientific terms used herein have the same meanings as commonly understood by those skilled in the art to which the present invention belongs.

It will be further understood that terms, such as those defined in commonly used dictionaries, should be interpreted as having a meaning that is consistent with their meaning in the context of the relevant art and should not be interpreted in an idealized or overly formal sense unless expressly so defined herein.

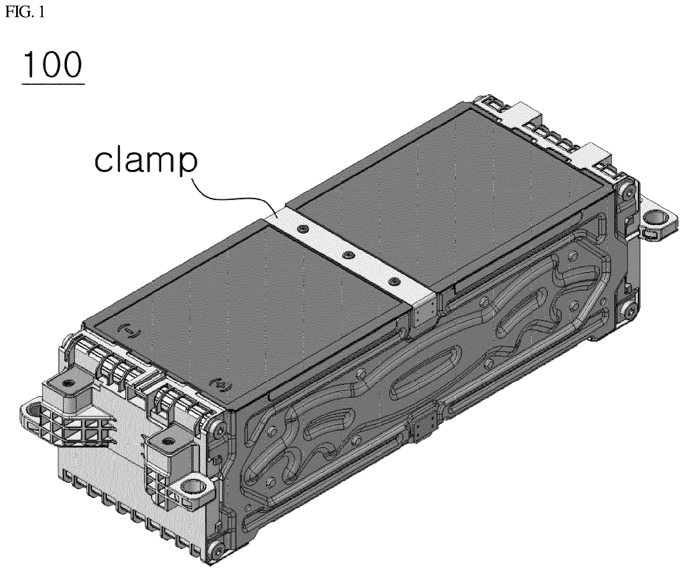

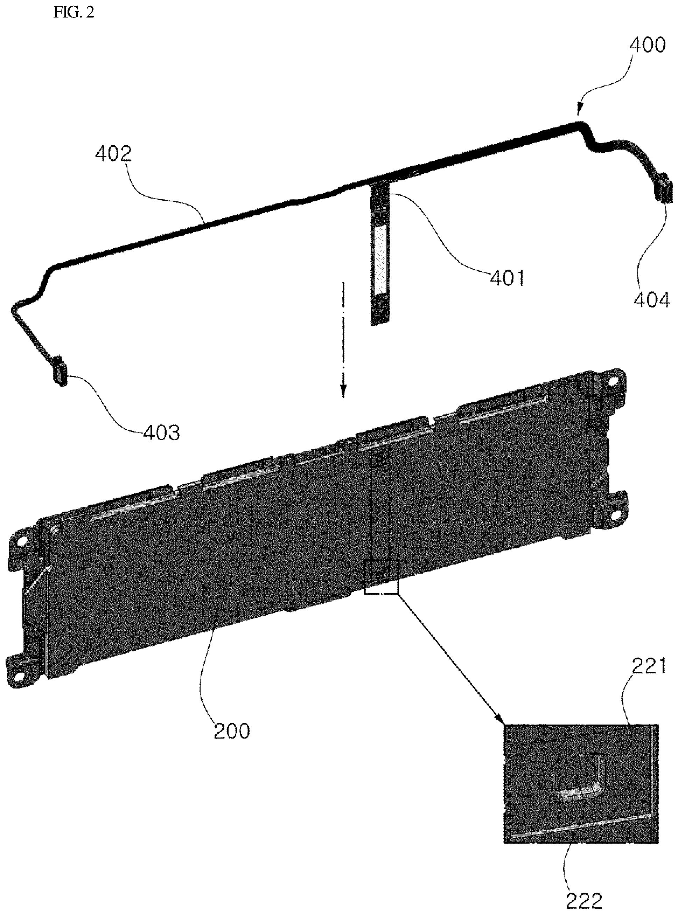

FIG. 1 is a perspective view illustrating a battery module 100 according to a preferred embodiment of the present invention, and FIG. 2 illustrates the end plate part 200 located on both sides of the battery module according to a preferred embodiment of the present invention.

The end plate part 200 includes an inner plate part 220 in contact with the cells, an outer plate 210 positioned outward from the inner plate part, and an air gap part 201 formed between the inner plate part 220 and the outer plate part 210, and first and second guide parts 202 and 203 may be formed on the upper portion of the inner plate part 220 to support a wire part 402.

The wire part 402 is positioned on the upper portion of the end plate part 200, particularly on the upper part of the inner plate 220.

In detail, the wire part 402 is installed lengthwise along the top of the end plate part 200 in the longitudinal direction of the end plate part 200.

The air gap part 201 may form a predetermined air layer inside the end plate part 200.

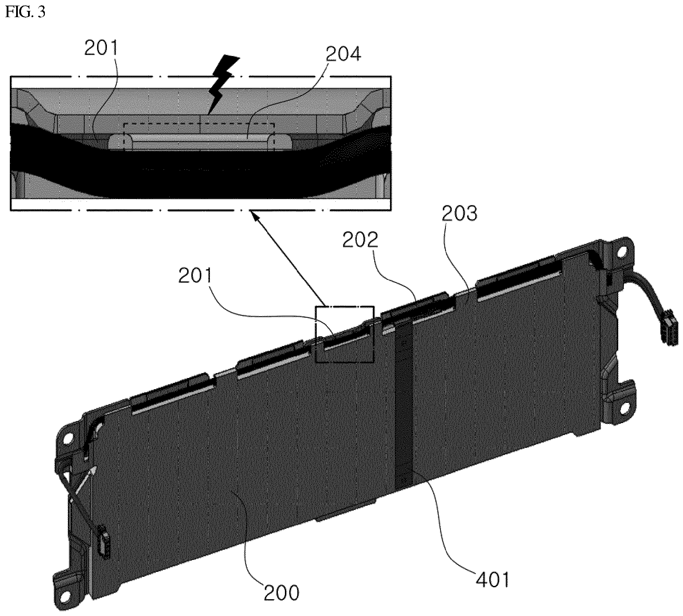

When the clamp (see FIG. 1) supporting the cells and left and right end plate parts 200 along the top of the battery module 100 is welded to the outer plate 210, the high-temperature heat generated is dissipated through the air gap part 201, preventing direct thermal stress on the wire part 402. The inner plate part 220 is provided with a protrusion 204 formed on one surface thereof to create an air gap part 201 between the inner plate part 220 and the outer plate part 210, and as shown in the enlarged top view in FIG. 3, the air gap part 201 may include the space between the wire part 402 and the outer plate part 210 as well as the space formed by the contact between the protrusion 204 of the inner plate 220 and the outer plate part 210.

As a result, the air gap part 201 may protect the wire part 402 from the heat generated during welding in a predetermined area of the end plate part 200.

Meanwhile, the first and second guide parts 202 and 203 are each protruded upward from the top of the end plate part 200.

Here, the first guide part 202 and the second guide part 203 may be formed at different positions along the length direction of the top of the end plate part 200, i.e., formed in a zigzag pattern on the top sides of the end plate part 200.

The first guide part 202 and the second guide part 203 may guide the wiring operation of the wire part 402.

That is, the first guide part 202 and the second guide part 203 may play a role in guiding and supporting the wire part 402.

The battery cell 300 may sense the temperature of the upper and lower parts of the internal battery cell enclosed by the end plate part 200.

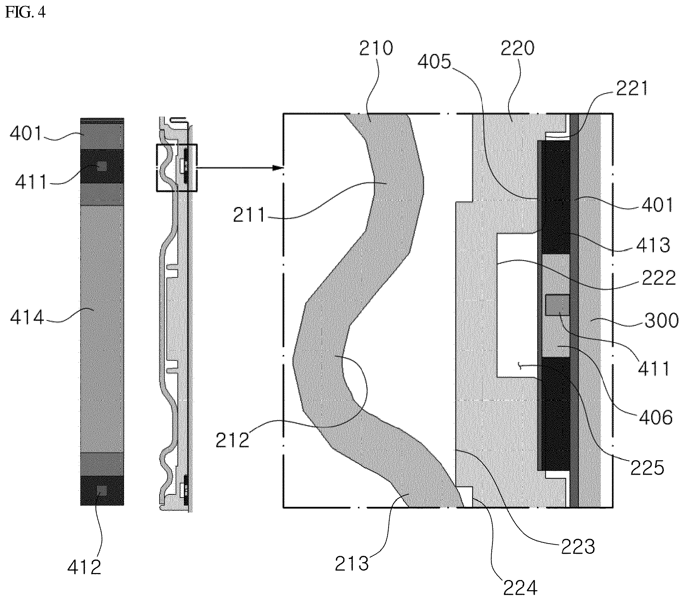

FIG. 3 is a perspective view illustrating an end plate 200 according to a preferred embodiment of the present invention, and FIG. 4 is a cross-sectional view illustrating an end plate part 200 according to a preferred embodiment of the present invention.

The unified sensor part 400 is installed on the end plate part 200 to sense at least one of the voltage or temperature of the battery cell 300.

The first voltage sensing part 403 and the second voltage sensing part 404 form the opposite ends of the wire part 402, respectively.

The temperature sensing part 401 is mounted on the flexible printed circuit board (FPCB) on the wire part 402.

The temperature sensor 401 is provided on the FPCB positioned on the inner wall of the inner plate part 220.

Here, the inner wall of the end plate part 200 faces the battery cell.

In more detail, the end plate part 200 may be composed of an outer plate part 210 and an inner plate part 220, the inner plate part 220 being positioned to face the battery cell 300.

Therefore, the temperature sensing part 401 and the wire part 402 may be integrally attached to the end plate part 200.

Here, the end plate part 200 may be provided with a first recessed portion 221 and a second recessed portion 222 that are formed to correspond to the temperature sensing part 401.

The first and second recessed portions 221 and 222 are formed in the end plate part 200 in a stepwise manner such that the depth of the second recessed portion 222 is deeper than that of the first recessed portion 221.

A pair of the first and second portions 221 and 222 is provided on both the upper and lower parts of the inner wall of the end plate part 200.

Meanwhile, the temperature sensing part 401 is elongated and narrow in the height direction of the end plate part 200 and takes the form of a flat bar-shaped FPCB with a predetermined width.

The temperature sensing part 401 includes a first temperature sensor 411 positioned on the upper part thereof and a second temperature sensor 412 positioned on the lower part thereof.

An adhesive portion 414 is provided on the temperature sensing part 401 between the first and second temperature sensors 411 and 412 and adhered to the inner wall of the inner plate part.

The adhesive portion 414 is a double-sided tape with a predetermined adhesive strength to attach the temperature sensing part 401 in the form of an FPCB to the inner plate part 220.

Hereinafter, a description is made of the installation structure of the first temperature sensor 411 in detail.

The end plate part 200 may have an outer plate part 210 and an inner plate part 220 as mentioned above.

The outer plate part 210 may have a first round portion 211, a second round portion 212, and a third round portion 213.

The first round portion 211 is curved toward the inner plate part 220 with a predetermined curvature.

The second round portion 212 has a predetermined curvature convex in the direction away from the inner plate part 220, extending from the first round portion 211.

The third round portion 213 has a predetermined curvature concave in the direction towards the inner plate part 220, extending from the second round portion 212.

The inner plate part 220 may have a first recessed portion 221 and a second recessed portion 222, which are recessed at different depths.

That is, the inner plate part 220 may have the first recessed portion 221, the second recessed portion 222, the first side part 223, and the second side part 224.

The first side part 223 is a portion from protruding the inner plate part 220 towards the outer plate part 210, and the bottom of the first side part 223 may make a contact with the third round portion 213.

The second side part 224 forms a step from the first side part 223.

The temperature sensing part 401 including the first temperature sensor 411 is positioned between the inner plate part 220 and the battery cell 300.

Technically, when the end plate part 200 is assembled onto the side of the battery cell 300 in the state where the temperature sensing part 401 is attached to the inner plate part 220 of the end plate part 200, automatic bonding occurs between the temperature sensing part 401 and the battery cell 300, and simultaneously, the first temperature sensor 411 aligns with the first recessed portion 221.

In more detail, the first temperature sensor 411 may be located at the center of the pad part 413 provided on the temperature sensing part 401.

Here, the pad part 413 may be a polyurethane pad. Between the pad part 413 and the first temperature sensor 411, a temperature sensor protection portion 406 is formed with epoxy to protect the temperature sensor, and the surface of the pad part 413 and the epoxy temperature sensor protection portion 406 are taped with a temperature sensor protection cover 405 to be in contact with the inner surface of the inner plate part 220.

Meanwhile, the pad part 413 may come into contact with the first recessed portion 221.

The second recessed portion 222 is formed deeper than the first recessed portion 221.

A compartment 225 is formed between the pad part 413 and the second recessed portion 222.

The compartment 225 provides an accommodation space for the first temperature sensor 411 when the battery cell 300 swells and to mitigate the impact to the inner plate 220, thereby preventing damage to the first temperature sensor 411.

In other words, the compartment 225 is designed to prevent direct contact between the first temperature sensor 411 and the inner plate part 220, even when the battery cell 300 swells and expands, exerting pressure on the first temperature sensor 411 towards the inner plate part 220, thereby mitigating the risk of potential damage.

In addition, even during excessive swelling of the battery cell 300, the space provided by the outer plate part 210 between the second round portion 212 and the inner plate part 220 allows for the dispersion of impact forces, preventing damage to the first temperature sensor 411 and ensuring accurate temperature measurement.

Moreover, the convex shape of the second round portion 212 facing outward allows for mitigation of direct damage to the first temperature sensor 411 even when external impacts occur.

In other words, the first temperature sensor 411 is shielded from damage caused by battery swelling inside the battery pack by the compartment 225 formed by the second recessed portion 222, and doubly protected from external impact by the second round portion 212.

In such a structure, the second temperature sensor 412 can also be prevented from being damaged by direct contact with the inner plate part 220 when the battery cell 300 swells.

That is, the compartment 225 can be similarly provided at a position corresponding to the second temperature sensor 412 on the inner plate part 220.

According to this invention, the following effects are achieved.

Firstly, the present invention offers the advantages of a simplified structure, enhanced assemblability, and immediate and accurate detection of battery cell abnormalities.

Secondly, the present invention offers the advantages of maximizing productivity through the automation and minimization of module processes.

### DESCRIPTION OF REFERENCE NUMERALS

100: battery module
200: end plate part
201: air gap part
202: first guide part
203: second guide part
210: outer plate part
211: first round portion
212: second round portion
213: third round portion
220: inner plate part
221: first recessed portion
222: second recessed portion
223: first side part
224: second side part
225: compartment
300: battery cell
400: unified sensor part
401: temperature sensing part
402: wire part
403: first voltage sensing part
404: second voltage sensing part
405: temperature sensor protection cover
406: temperature sensor protection portion
411: first temperature sensor
412: second temperature sensor
413: pad part
414: adhesive portion

## Claims

1. A unified battery cell sensor integrated battery module comprising:
an end plate part 200 positioned on the left and right sides of the battery module; and
a unified sensor part 400 formed integrally on the end plate part 200 and configured to sense at least one of voltage or temperature of a battery cell 300.

2. The battery module of claim 1, wherein the unified sensor part 400 comprises:
a wire part 402 comprising a first voltage sensing part 403 and a second voltage sensing part 404 configured each to measure voltage at the front and rear ends of the battery module; and
a temperature sensing part 401 formed integrally on the wire part 402 and configured to contact the battery cell 300 and sense the temperature of the battery cell 300.

3. The battery module of claim 2, wherein the end plate part 200 comprises:
an outer plate part 210; and
an inner plate part 220 coupled with the outer plate part 210 on one side thereof and facing the battery cell 300 on the other side,
wherein the temperature sensing part 401 is positioned between the inner plate part 220 and the battery cell 300.

4. The battery module of claim 3, wherein the temperature sensing part 401 comprises a temperature sensor configured to sensing the temperature of the battery cell 300, and the inner plate part 220 comprises a compartment 225 facing the outer plate part 210 at a position corresponding to the temperature sensor to accommodate the temperature sensor in response to swelling of the battery cell 300.

5. The battery module of claim 4, wherein the temperature sensor comprises a first temperature sensor 411 and a second temperature sensor 412 positioned at a predetermined distance from each other vertically.

6. The battery module of claim 5, wherein the first temperature sensor 411 is positioned on the upper side of the temperature sensing part 401 to sense the temperature at the top of the battery cell 300, and the second temperature sensor 412 is positioned on the lower side of the temperature sensing part 401 to sense the temperature at the bottom of the battery cell 300.

7. The battery module of claim 6, wherein the temperature sensing part 401 comprises a pad part 413 around each of the first temperature sensor 411 and the second temperature sensor 412, and the inner plate part 220 comprises a first recessed portion 221 and a second recessed portion 222 formed deeper than the first recessed portion 221 facing the outer plate 210, the pad part 413 being situated in the first recessed portion 221.

8. The battery module of claim 7, wherein the first temperature sensor 411 is mounted at the center of the pad part 413.

9. The battery module of claim 7, wherein the outer plate part 210 comprises a second round portion 212 formed in a convex shape away from the inner plate 220 at a position facing each of the first temperature sensor 411 and the second temperature sensor 412.

10. The battery module of claim 4, wherein the temperature sensing part 401 comprises an adhesive portion 414 to be fixed to the inner plate part 220.

11. The battery module of claim 10, wherein the adhesive portion 414 is positioned between the first temperature sensor 411 and the second temperature sensor 412.

12. The battery module of claim 1, wherein the end plate part 200 comprises an air gap part 201 configured to dissipate heat generated during welding.

13. The battery module of claim 3, wherein the end plate part 200 comprises a first guide part 202 and a second guide part 203 protruded upward at the top thereof to guide the wiring work of the wire part 402.

14. The battery module of claim 13, wherein the first guide part 202 and the second guide part 203 are formed in a zigzag pattern at the top of the inner plate part 220.

15. A unified battery cell sensor integrated battery module comprising:
an end plate part 200 contacting a battery cell 300; and
a unified sensor part 400 provided integrally on the end plate part 200 and configured to sense at least one of voltage or temperature of a battery cell 300,
wherein the unified sensor part 400 comprises:
a wire part 402 comprising a first voltage sensing part 403 and a second voltage sensing part 404 configured each to measure voltage at the front and rear ends of the battery module; and
a temperature sensing part 401 formed integrally on the wire part 402 and configured to contact the battery cell 300 and sense the temperature of the battery cell 300, the temperature sensing part 401 comprising a first temperature sensor 411 and a second temperature sensor 412 to measure temperature at the top and bottom of the battery module.
